(19) Europäisches Patentamt
European Patent Office
Office européen des brevets

(11) **EP 2 919 388 A1**

(12) **EUROPEAN PATENT APPLICATION**

(43) Date of publication:
**16.09.2015 Bulletin 2015/38**

(51) Int Cl.:
***H03M 3/00*** *(2006.01)*

(21) Application number: **14160161.7**

(22) Date of filing: **14.03.2014**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **NXP B.V.**
**5656 AG Eindhoven (NL)**

(72) Inventors:
• **Sebastiano, Fabio**
**5656 AG Eindhoven (NL)**

• **Van Veldhoven, Robert Henrikus Margaretha**
**5656 AG Eindhoven (NL)**
• **Ersoy, Selcuk**
**5656 AG Eindhoven (NL)**

(74) Representative: **Terblanche, Candice Jane**
**NXP Semiconductors**
**Intellectual Property and Licensing**
**Red Central**
**60 High Street**
**Redhill, Surrey RH1 1SH (GB)**

(54) **Modulator with high signal to noise ratio**

(57)    In summary, there is provided a modulator (200) comprising: a quantizer (106); an input path (118) to the quantizer (106) for feeding an quantizer input signal (120) to the quantizer (106); a feedback path (128) for providing a feedback signal (130) to the input path (118), the feedback signal (130) representing an output (132) of the quantizer (106), the output (132) comprising a quantization noise spectrum; and a circuit component (138) configured to attenuate the quantization noise spectrum at a fold-back frequency from which noise is folded back into a signal band of interest of the quantizer input signal. Attenuation of the quantization noise spectrum may be performed e.g. by one or more suitable filters, an error- feedback loop, etc.

Fig. 9

EP 2 919 388 A1

**Description**

FIELD OF THE INVENTION

The present invention relates to the field of analog/digital converters and in particular to such converters including a sigma-delta modulator.

BACKGROUND

US 2012/0038500 AI discloses a low power, high dynamic range sigma-delta modulator comprising a quantizer followed by a digital integrator for generating an integrated digital signal from a quantized signal. The output of the digital integrator is coupled to a digital-to-analog converter in the feedback loop of the sigma-delta modulator.
US 2012/0188107 AI discloses a continuous time oversampled converter having enhanced immunity to noise.
Analog-to-digital converters (ADC) comprising a sigma-delta modulator are often used for digital acquisition of signals, such as signals generated by sensors. For many applications, the ADC has strict requirements on its input offset and on its input referred noise. To reduce the offset and avoid large low frequency noise (such as flicker noise), the first stage of the sigma-delta converter is often chopped.

SUMMARY

A drawback of chopping the sigma-delta modulator is that quantization noise at high frequency can be folded back at low frequency (i.e. a signal band of interest) due to non-idealities of the chopping.
In view of the above-described situation, there exists a need for an improved technique that enables to provide a modulator which provides a good signal quality.
This need may be met by the subject-matter according to the independent claims. Advantageous embodiments of the herein disclosed subject-matter are described by the dependent claims.
According to an embodiment of a first aspect of the herein disclosed subject-matter, there is provided a modulator, in particular a sigma-delta modulator, the modulator comprising: a quantizer, an input path to the quantizer for feeding an quantizer input signal to the quantizer; a feedback path for providing a feedback signal to the input path, the feedback signal representing an output of the quantizer, the output comprising a quantization noise spectrum; and a circuit component configured to attenuate the quantization noise spectrum at a fold back frequency from which noise is folded back into a signal band of interest of the quantizer input signal.
This aspect of the herein disclosed subject-matter is based on the idea that by attenuating the output of the quantizer at least in one or more frequencies from which noise is folded back into the signal band of interest of the quantizer input signal (via the feedback path), feedback of quantization noise is reduced or even suppressed and hence the signal quality of the output of the quantizer is improved. For example, when implementing a chopping modulation in the modulator, this idea could be realized by shaping the quantization noise so as to minimize the amount of quantization noise around the even harmonics of the chopping frequency which may be folded back due to non-idealities of the chopping modulation.
According to an embodiment of a second aspect of the herein disclosed subject-matter, a method of operating a quantizer of a modulator (e.g. a sigma-delta modulator) is provided, the method comprising: feeding an quantizer input signal to the quantizer; providing a feedback signal to the input path, the feedback signal representing an output of the quantizer, the output comprising a quantization noise spectrum; and attenuating the quantization noise spectrum at a fold back frequency from which noise is folded back into a signal band of interest of the quantizer input signal.
According to embodiments of the second aspect, the method is adapted for providing the functionality as described with regard to one or more of the herein mentioned aspects or embodiments and/or for providing the functionality as required or as resulting by one or more of the herein mentioned aspects or embodiments, in particular of the embodiments of the first aspect.
According to an embodiment of a third aspect, a computer program product is provided, in particular in the form of a computer program or in the form of a computer-readable medium comprising the computer program, for controlling the operation of a modulator, the computer program being configured for, when being executed on a data processor device, controlling the method according to the second aspect or an embodiment thereof.
According to embodiments of the third aspect, the computer program product is adapted for providing the functionality as described with regard to one or more of the herein mentioned aspects or embodiments and/or for providing the functionality as required or as resulting by one or more of the herein mentioned aspects or embodiments, in particular of the embodiments of the first and the second aspect.
According to an embodiment, for attenuating the quantizer input signal, the circuit component is configured for generating a notch in the quantization noise spectrum at the fold back frequency. Herein, notch has to be interpreted in a broad sense, i.e. the notch may extend over a certain bandwidth of the quantization noise spectrum. In other words, the notch in the quantization noise spectrum is not necessarily limited to the fold back frequency but may rather have a certain bandwidth including the fold back frequency.

According to a further embodiment, the input path comprises an analog filter; a chopping modulator coupled to the filter and configured for operating at a chopping frequency; wherein the fold back frequency is a function of the chopping frequency. According to an embodiment, the analog filter is a loop filter of the sigma-delta modulator and may be in particular a first stage of the loop filter of the sigma-delta modulator. The chopping modulator may serve to reduce an input offset and/or avoid large low frequency noise such as flicker noise. However, as described herein, the chopping of the analog filter may result in a quantization noise at high frequency being folded back due to non-idealities of the chopping. Hence, it is possible to mitigate signal degradation due to folding back of quantization noise if the fold back frequency at which the quantization noise spectrum is attenuated according to embodiments of the herein disclosed subject-matter, is a function of the chopping frequency. In other words, the fold back frequency at which the quantization noise spectrum is to be attenuated is given as a function of the chopping frequency in this embodiment.

According to an embodiment, the fold back frequency is an even harmonic of the chopping frequency. Hence, by specifying the chopping frequency, it is possible to configure the circuit component accordingly to attenuate the quantization noise spectrum at even harmonics of the chopping frequency.

According to an embodiment, the chopping modulator is configured for operating at a chopping frequency fchop = fs/2p, wherein fs is the sampling frequency of the quantizer and p is an integer. In such a case, the circuit component can be implemented as a finite impulse response (FIR) filter. However, in a more general embodiment, the circuit component is a filter.

According to a further embodiment, the circuit component comprises a filter (e.g. a digital filter or an analogue filter) coupled between an output of the quantizer and the feedback path, a transfer function of the filter having notches at even harmonics of the chopping frequency. According to an embodiment, the magnitude of the digital filter is as low as possible at the fold back frequency (i.e. at the frequency where the digital filter has to generate the notch in the quantization noise spectrum).

In a more general embodiment, the transfer function of the digital filter has a notch at at least one fold back frequency from which noise is folded back into the signal band of interest of the quantizer input signal.

According to an embodiment, the digital filter is a finite impulse response filter.

According to a further embodiment, the feedback path is a first feedback path and the circuit component comprises a second feedback path coupling an output of the quantizer to the input path. By the second feedback path, the stability of the loop may be improved.

According to an embodiment, the analog filter is a first analog filter and the input path comprises a second analog filter coupled between the first analog filter and the input of the quantizer; wherein the second feedback path is coupled to the second analog filter.

According to an embodiment, the circuit component comprises an error feedback loop; the error feedback loop being coupled to the input of the quantizer and to the output of the quantizer and being configured for generating a signal representative of a quantization error of the quantizer; the error feedback loop being further coupled to the input path for subtracting the signal indicative of the quantization error from the quantizer input signal provided to the quantizer. In other words, according to an embodiment, the attenuation of the quantization noise spectrum at the fold back frequency is performed by generating the signal representative of the quantization error of the quantizer and subtracting this signal from the quantizer input signal, thereby attenuates the quantization noise spectrum in the output of the quantizer.

According to an embodiment, the error feedback loop comprises an analog filter for passing the signal indicative of the quantization error at the fold back frequency. For example, in an embodiment, the analog filter is configured so as to provide a transfer function which is close to one at the fold back frequency.

According to an embodiment, a second digital filter is coupled between the output of the quantizer and an output of the modulator.

As used herein, reference to a computer program product is intended to be equivalent to a reference to a program element and/or a computer readable medium containing instructions for controlling a computer system to effect and/or coordinate the performance of the above described method.

The computer program may be implemented as computer readable instruction code by use of any suitable programming language, such as, for example, JAVA, C++, and may be stored on a computer-readable medium (removable disk, volatile or non-volatile memory, embedded memory/processor, etc.). The instruction code is operable to program a computer or any other programmable device to carry out the intended functions. The computer program may be available from a network, such as the World Wide Web, from which it may be downloaded.

The herein disclosed subject matter may be realized by means of a computer program respectively software. However, the herein disclosed subject matter may also be realized by means of one or more specific electronic circuits respectively hardware. Furthermore, the herein disclosed subject matter may also be realized in a hybrid form, i.e. in a combination of software modules and hardware modules.

In the above there have been described and in the following there will be described exemplary embodiments of the subject matter disclosed herein with reference to a modulator, a method of operating a quantizer or a modulator and respective methods and computer program products. It has to be pointed out that of course any combination of features relating to different aspects of the herein disclosed subject matter is also possible. In particular, some features have been or will be described with reference to apparatus type embodiments whereas other features have been or will be described with reference to method type embodiments. However, a person skilled in the art will gather from the above and the following description that, unless other notified, in addition to any combination of features belonging to one aspect also any combination of features relating to different aspects or embodiments, for example even combinations of features of apparatus type embodiments and features of the method type embodiments are considered to be disclosed with this application.

The aspects and embodiments defined above and further aspects and embodiments of the herein disclosed subject matter are apparent from the examples to be described hereinafter and are explained with reference to the drawings, but to which the invention is not limited.

BRIEF DESCRIPTION OF THE DRAWINGS

Fig. 1 shows an exemplary sigma-delta modulator with chopping modulation of a filter stage according to embodiments of the herein disclosed subject-matter.
Fig. 2 shows an exemplary chopper modulation signal in the form of a square wave.
Fig. 3 shows the relevant parts for an exemplary chopping modulation.
Fig. 4 shows for comparison again the chopping modulation signal in the form of a square wave.
Fig. 5 shows the input signal a(t) to the first mixer.
Fig. 6 shows the input signal b(t) to the first filter over time t.
Fig. 7 shows the output signal c(t) of the filter over time.
Fig. 8 shows the output signal d(t) over time.
Fig. 9 shows a modulator according to embodiments of the herein disclosed subj ect matter.
Fig. 10 shows a further modulator according to embodiments of the herein disclosed subject matter.
Fig. 11 shows a modulator according to embodiments of the herein disclosed subject matter.
Fig. 12 schematically shows the modulator output signal (output spectrum) y over frequency f.
Fig. 13 schematically shows the modulator output signal y over frequency f according to embodiments of the herein disclosed subject matter.

DETAILED DESCRIPTION

The illustration in the drawings is schematic. It is noted that in different figures, similar or identical elements are provided with the same reference signs or with reference signs which are different from the corresponding reference signs only within the first digit. Accordingly, the description of similar or identical features is not repeated in the description of subsequent figures in order to avoid unnecessary repetitions. However, it should be understood that the description of these features in the preceding figures is also valid for the subsequent figures unless noted otherwise.

In the following, chopper modulation of an exemplary sigma-delta modulator is described to provide a more thorough understanding of the subject matter disclosed herein, followed by several example implementations of embodiments of the herein disclosed subject-matter.

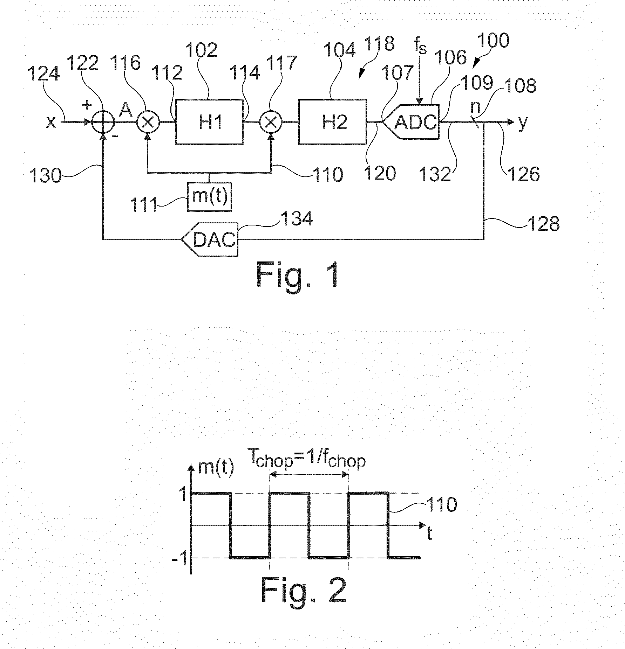

Fig. 1 shows an exemplary sigma-delta modulator with chopping modulation of a filter stage according to embodiments of the herein disclosed subject-matter.

The sigma-delta modulator 100 comprises two loop filters 102, 104 wherein a first loop filter is also denoted H1 and a second loop filter 104 is also denoted H2. Further, the modulator 100 comprises a quantizer 106 in the form of an analog-digital converter (ADC) 106. The quantizer 106 has an input 107 (e.g. an input terminal) and an output 109 (e.g. an output terminal). The quantizer 106 is an n bit quantizer providing an n bit output, indicated at 108.

Implemented in the modulator 100 is chopper modulation of the first filter 102. To this end, a chopping signal 110, m(t), is imposed on the input 112 and the output 114 of the first filter 102, e.g. by mixers 116, 117, as shown in Fig. 1. The chopping signal 110 is provided by a chopping modulator 111.

In accordance with an embodiment, the first filter 102, the second filter 104 and the mixers 116, 117 form part of an input path 118 for feeding a quantizer input signal 120 to the quantizer 106. According to an embodiment, the input path 118 further comprises a summing point 122. In operation, the modulator 100 receives at an input 124 (modulator input) an input signal (modulator input signal) x and provides at its output 126 (modulator output) an output signal (modulator output signal) y.

In accordance with an embodiment, the modulator 100 comprises a feedback path 128 for providing a feedback signal 130 to the input path 118, the feedback signal 130 representing an output 132 of the quantizer, wherein the output 132 of the quantizer 106 comprises a quantization noise spectrum. The feedback signal 130 is representative of the output 132 of the quantizer. In accordance with an embodiment, the feedback path 128 comprises a digital-to-analog converter (DAC) 134 which serves to provide the feedback signal 130 in the analogue domain.

Next, the chopper modulation is briefly discussed. Fig. 2 shows an exemplary chopper modulation signal 110 in the form of a square wave. Further illustrated in Fig. 2 is the chopping frequency $f_{chop}$ and its corresponding oscillation period $T_{chop}$.

The chopper modulation provides suppression of low frequency noise. However, a drawback of this architecture is that quantization noise at high frequency in the quantizer output 132 can be folded back into a (low frequency) signal band of interest. This folding back of quantization noise may occur due to non-idealities of the chopping modulation.

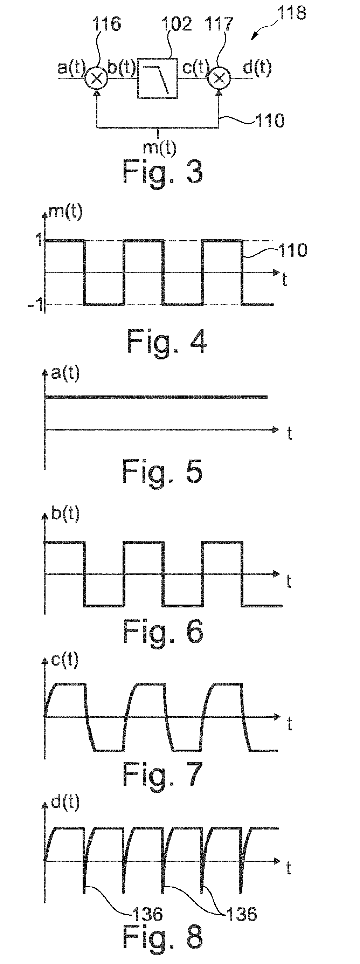

Fig. 3 shows the relevant parts for the chopping modulation, wherein signals at different stages of the input path 118 are referred to by a(t), b(t), c(t), d(t) and are discussed with regard to Fig. 4 to Fig. 8. In Fig. 3, the individual elements are denoted by the same reference signs as in Fig. 1 and the detailed description thereof is not repeated here.

Fig. 4 shows for comparison again the chopping modulation signal 110 in the form of a square wave, as already shown in Fig. 2. Fig. 5 shows the input signal a(t) to the first mixer 116. Exemplarily and only for illustrative purposes, the signal a(t) is a signal constant over time t.

Fig. 6 shows the input signal b(t) to the first filter 102 over time t. This input signal to the filter 102 has been modulated with the chopper modulation signal 110 and hence reproduces a square wave for the signal a(t).

If the circuit (e.g. the filter 102) between the first mixer 116 (input chopper) and the second mixer 117 (output chopper) exhibits a low pass frequency response, settling transients are present at the output of it, which can be seen in Fig. 7 showing the output signal c(t) of the filter 102 over time. Due to the presence of those transients, the output signal d(t), shown in Fig. 8 over time t, contains both the reconstructed input signal a(t) and a disturbance in form of peaks (some of which are indicated at 136 in Fig. 8) with frequency $2f_{chop}$ and amplitude proportional to the input signal. In practice, this is equivalent of adding at the output the second mixer 117 a scaled version of the input signal sampled with frequency $2f_{chop}$.

From the above consideration, if the same reasoning is applied to the input path 118 in Fig.1 it is clear that, if the first filter 102 shows a low-pass frequency response, the signal at the input of the second filter 104 will contain a disturbance similar to the peaks 136 shown in Fig. 8. This disturbance will be proportional to the signal at node A sampled with sampling frequency $2f_{chop}$. The signal at A is the difference of x and the feedback signal 130. As common in Sigma Delta converters, the feedback signal 130 contains both signal components and quantization noise. Consequently, at the input of the second filter 104 a disturbance proportional to the quantization noise of the converter sampled at $2f_{chop}$ is present. Due to the sampling, quantization noise present in the spectrum at frequencies $k \cdot 2f_{chop}$ (with k integer) will fold around DC, increasing the noise floor in the signal band of interest. This effect can then degrade the signal-to-noise ratio of the modulator 100.

The degradation of the signal-to-noise ratio is lower if the first filter 102 has a large bandwidth with respect to the chopping frequency $f_{chop}$. However, parasitic behaviour of the circuit implementing the first filter 102 will limit its bandwidth. Moreover, since the quantization noise at high frequency is usually much higher than the quantization noise in the signal band of interest, even with a large bandwidth of the first filter 102 and, consequently, a reduced folding-back, the signal-to-noise ratio degradation can be significant.

To avoid degradation of the sigma-to-noise due to folding back of quantization noise around even harmonics of the chopping frequency, embodiments of the herein disclosed subject matter propose to shape the quantization noise so as to minimize the amount of quantization noise around the even harmonics of the chopping frequency.

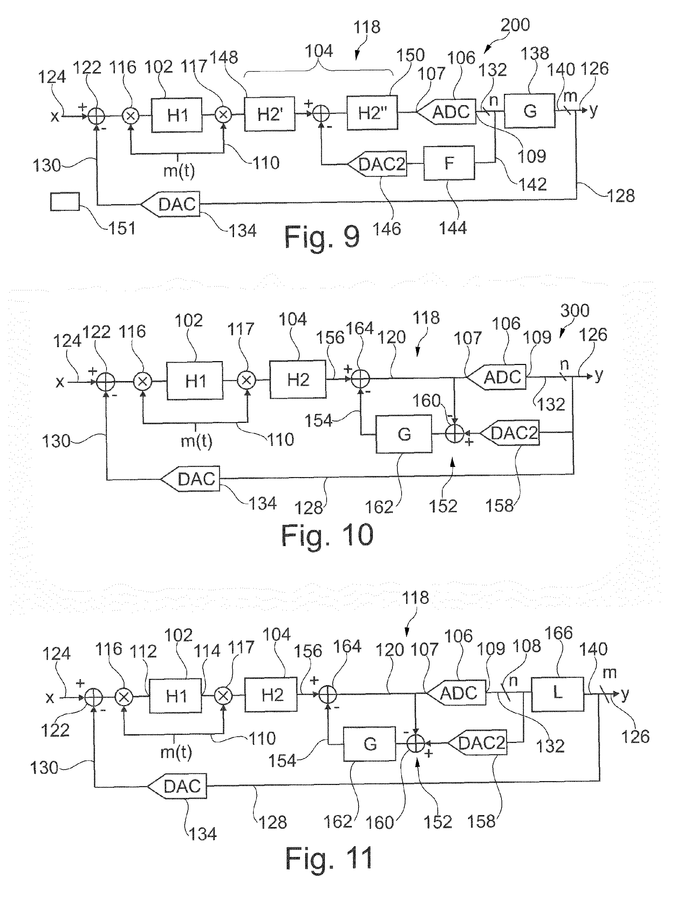

Such a shaping of the quantization noise or, in a more general embodiment the attenuation of the quantization noise spectrum at at least one fold back frequency, may be realized by any suitable way, e.g. by the two architectures that are discussed in Fig. 9 on the one hand and in Fig. 10 and 11 on the other hand.

Fig. 9 shows a modulator 200 according to embodiments of the herein disclosed subject matter. In particular, the modulator 200 implements a Sigma Delta architecture with a digital filter 138. According to an embodiment, the digital filter 138 has a transfer function G and is coupled between an output of the quantizer 106 and the feedback path 128.

Compared to the modulator 100 in Fig. 1, the digital filter 138 is according to an embodiment added after the quantizer 106 (i.e. coupled between the output of the quantizer 106 and the feedback path 128). According to an embodiment, the digital filter 138 is configured to process the quantizer output 132 (with a width of n bits) and to generate an m-bit wide digital filter output 140 to drive the feedback digital to analogue converter 134. According to a further embodiment, the digital filter output 140 forms the modulator output 126.

Since the addition of filter 138 can degrade the stability of the loop, according to an embodiment an additional, second feedback path 142 is added. According to an embodiment, the second feedback path 142 couples an output of the quantizer 106 to the input path. In accordance with an embodiment, the additional feedback path 142 is composed by a second digital filter 144, which has a transfer function F, and a second digital to analogue converter 146, also referred to as DAC2 in Fig. 9. According to an embodiment, the second feedback path 142 is connected to the second filter 104. Generally, the second feedback path 142 may be connected at a point of the second filter 104. According to an embodiment, the second filter 104 with transfer function H2 is split into two parts, a first part 148 of the second filter 104 with transfer function H2' and a second part 150 of the second filter 104 with transfer function H2". Accordingly, the transfer function H2 of the second filter 104 is given by H2=H2'·H2".

By using the linear model of a Sigma Delta modulator and by assuming a gain of 1 for both digital to analogue converters 134, 144 (DAC and DAC2) and for the quantizer 106, the output y of the modulator 200 can be expressed as:

$$y = \frac{H_1 H_2 G}{1 + H_1 H_2 G + H_2'' F} x + \frac{G}{1 + H_1 H_2 G + H_2'' F} Q \cong x + \frac{G}{1 + H_1 H_2 G + H_2'' F} Q$$

where Q is the quantization noise introduced by the quantizer 106 and the approximation holds for

$H_1 H_2 G \gg 1 + H_2'' F$ in the signal bandwidth. From the previous equation, the quantization noise at the modulator output 126 (and consequently the quantization noise at the first mixer 116 (input chopper) of the first filter 102) will be attenuated by the digital filter 138 and will eventually be cancelled at the frequency locations of the zeros of its transfer function G. Thus, by proper selection of the chopping frequency $f_{chop}$ and of the frequency response of the digital filter 138, quantization noise can be minimized at the even harmonics of the chopping frequency $f_{chop}$ and folding back can be avoided or at least be reduced, thus avoiding or at least reducing a signal to noise ratio degradation by the quantization noise.

According to an embodiment, the digital filter 138 is implemented as a FIR filter. For example, if the chopping frequency $f_{chop}$ is chosen as

$$f_{chop} = \frac{f_s}{2p}$$

where $f_s$ is the sampling frequency of the quantizer and $p$ is an integer, the digital filter 138 can be implemented as a FIR filter with the following input-output response in the Z-domain:

$$G(z) = \sum_{n=0}^{p} z^{-1}$$

which has zeroes at all even harmonics of the chopping frequency $f_{chop}$.

An example implementation can be obtained by the following choices:

- n=1 (one-bit quantizer)
- m=⌊$log_2$(p+ 1)⌋
- H2"=1
- F is a low-pass digital filter to ensure stability

According to an embodiment, the modulator 200 comprises a data processor device 151 configured for executing a computer program for thereby controlling and/or implementing one or more other components of the modulator 200, e.g. components of the input path 118, the feedback paths 128, 142, the chopping modulator 111 (not shown in Fig. 9), etc.

Fig. 10 shows a modulator 300 according to embodiments of the herein disclosed subject matter. In particular, the modulator 300 implements a Sigma Delta architecture with a error-feedback loop 152.

According to an embodiment, the error-feedback loop 152 is coupled to the input 107 of the quantizer 106 and to the output 109 of the quantizer 106 and is configured for generating a signal 154 representative of a quantization error of the quantizer 106. According to a further embodiment, the error-feedback loop is further coupled to the input path 118 for subtracting the signal 154 indicative of the quantization error from a signal 156 in the input path 118 and thereby generating the quantizer input signal 120 which is provided to (fed into) the quantizer. Starting from the modulator of Fig. 1, the Sigma Delta architecture of Fig. 10 can be provided by adding the error-feedback loop 152 around the quantizer.

According to an embodiment, the error feedback loop 152 comprises a summing point 160 which is coupled to the input 107 of the quantizer and to the output 109 of the quantizer. The summing point 160 which determines the signal indicative of the quantization error, may be provided in the digital domain or, in another embodiment, in the analogue domain as shown in Fig. 10. For example, in an embodiment implementing the summing point in the analogue domain, a digital to analogue converter 158 (DAC2) is coupled between output 109 of the quantizer 106 and the summing point 160 while the input 107 of the quantizer is directly coupled to the summing point.

According to an embodiment, the error feedback loop 152 comprises a filter 162 (error feedback loop filter) coupled between the summing point 160 and the input path 118. The filter 162 may be a digital filter or an analogue filter. According to an embodiment, the filter 162 is an analog filter and is coupled between the summing point 160 and the input path 118. According to an embodiment, the input path 118 comprises a summing point 164 to which the output of the filter 162 in the error feedback loop 152 is coupled in order to subtract the signal 154 indicative of the quantization error from the signal 156 of the input path 118.

The error feedback loop filter 162 has a transfer function G that passes the signal 154 indicative of the quantization error at the fold back frequency. For example, according to an embodiment, the error feedback loop filter 162 provides a transfer function which is close to 1 at the fold back frequency for passing the signal 154 indicative of the quantization error at the fold back frequency.

The remaining features of the modulator 300 shown in Fig. 10 correspond to the respective features of the previously described modulators 100, 200 and the description thereof is not repeated here.

In another embodiment, compared to Fig. 10, the error feedback path section including the digital to analog converter 158 (i.e. the path section between the output 109 of the quantizer 106 and the summing point 160) is removed and the output of the feedback path 128 (e.g. the output of the digital-to-analogue converter 134) is coupled to the summing point 152 instead.

By using the linear model of the Sigma Delta modulator and by assuming a gain of 1 for both digital to analog converters 134, 158 and for the quantizer 106, the output y of the modulator 300 can be expressed as:

$$Y = \frac{H_1 H_2}{1 + H_1 H_2} X + \frac{1 - G}{1 + H_1 H_2} Q \cong X + \frac{1 - G}{1 + H_1 H_2} Q$$

where Q is the quantization noise introduced by the quantizer 106 and the approximation holds for $H_1 H_2 \gg 1$ in the signal band of interest. As can be taken from this equation, the quantization noise at the output (and consequently the quantization noise at the first mixer 116 (input chopper of the first filter 102) will be cancelled at the frequency locations where G=1.

According to an embodiment, and in particular for implementing the system in Fig. 10 $f_{chop}$ may be chosen as

$$f_{chop} = \frac{f_s}{2p}$$

where $f_s$ is the sampling frequency of the quantizer. Further, the error feedback loop filter 162 is a comb filter with the following frequency response:

$$G(j\omega) = a \left( 1 + e^{-j\omega \frac{p}{f_s}} \right)$$

which is equal to 2$a$ for all even harmonics of the chopping frequency, i.e.

$$G\left(j 2\pi \cdot 2k f_{chop}\right) = 2a$$

where *k* is an integer. Thus, by choosing *a*=0.5, in accordance with an embodiment, the quantization noise is cancelled at the even harmonics of $f_{chop}$. If according to a further embodiment *a* > 0.5, the quantization noise is not fully cancelled at the even harmonics of the chopping frequency but it is attenuated in a larger bandwidth around each of those even harmonics. This can be useful if the signal band of interest is relatively large and quantization noise from a wider band around the even harmonics of $f_{chop}$ can fold into the signal band of interest.

Fig. 11 shows a modulator 400 according to embodiments of the herein disclosed subject matter. In particular, the modulator 400 implements a further Sigma Delta architecture with a error-feedback loop 152.

The modulator 400 shown in Fig. 11 corresponds to the modulator of 300 shown in Fig. 10 except for the additional digital filter 166 with a transfer function L between the output 109 of the quantizer 106 and the modulator output 126.

The addition of the digital filter does not affect the feature of avoiding SNR degradation due to chopping. The digital filter L is used to convert the n-bit output of the quantizer to an m-bit word and thus use an m-bit DAC. An example implementation of this architecture can be obtained with the following choices:

- Q is an 1.5 bit quantizer
- L is a digital integrator
- G is an analog comb filter as previously described

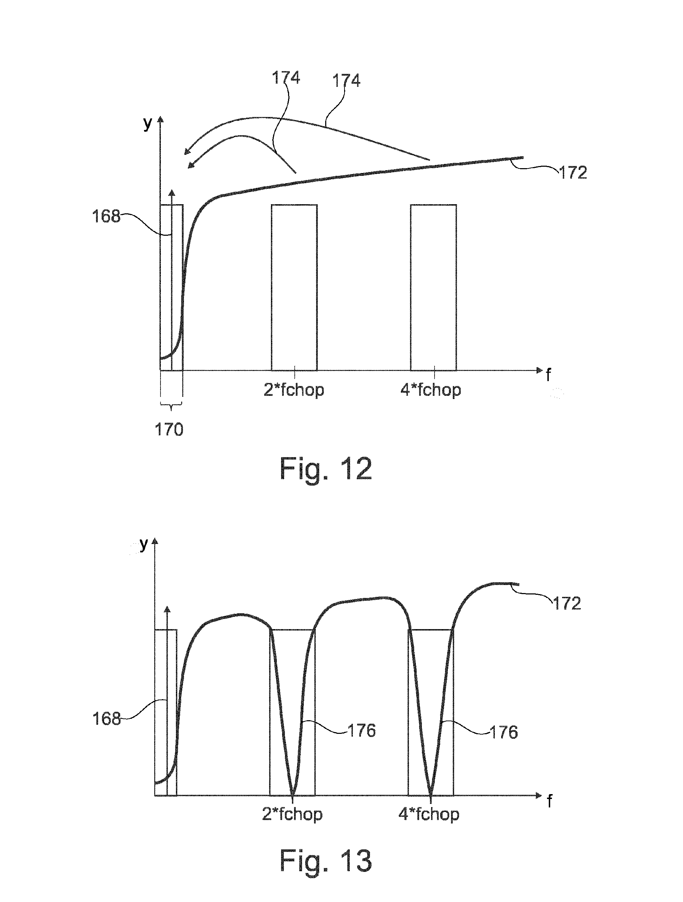

Fig. 12 schematically shows the modulator output signal (output spectrum) y over frequency f if embodiments of the herein disclosed subject matter are not employed. In particular, the modulator output signal y comprises a signal component 168 in signal band of interest 170 as well as quantization noise 172. Further shown in Fig. 12 are the even harmonics of the chopping frequency, $2*_{fchop}$ and $4*f_{chop}$. Folding back of the quantization noise 172 at these frequencies to the signal band of interest 170 is indicated at 174 in Fig. 12.

Fig. 13 schematically shows the modulator output signal y over frequency f according to embodiments of the herein disclosed subject matter. In accordance with an embodiment, the spectrum of the quantization noise 172 comprises a notch 176 at each even harmonic of the chopping frequency.

As is apparent from the examples and embodiments herein, the circuit component for attenuating the quantization noise spectrum at a fold-back frequency can be a filter or an error feedback path. However, it should be understood that any other suitable circuit component is also possible as long as the quantization noise at the fold-back frequency is attenuated.

Embodiments of the herein disclosed subject matter can be used in numerous applications, e.g. applications that require a low-offset and/or low-noise analog to digital converter. Typical applications include sensor systems, where a high resolution conversion of a relatively low-frequency signal is required, as well as (narrow band) radio systems and audio systems. Examples are magnetic sensors for speed or angular sensing. For example, for the combination of chopping and generating notches in the quantization noise spectrum according to embodiments of the herein disclosed subject matter, on top of having better jitter noise immunity, also a low offset without having noise folding may be provided.

In summary, there is provided a modulator (200) comprising: a quantizer (106); an input path (118) to the quantizer (106) for feeding an quantizer input signal (120) to the quantizer (106); a feedback path (128) for providing a feedback signal (130) to the input path (118), the feedback signal (130) representing an output (132) of the quantizer (106), the output (132) comprising a quantization noise spectrum; and a circuit component (138) configured to attenuate the quantization noise spectrum at a fold-back frequency from which noise is folded back into a signal band of interest of the quantizer input signal. Attenuation of the quantization noise spectrum may be performed e.g. by one or more suitable filters, an error-feedback loop, etc.

**Claims**

1. Modulator (100, 200, 300, 400) comprising:

   a quantizer (106);
   an input path (118) to the quantizer (106) for feeding an quantizer input signal (120) to the quantizer (106);
   a feedback path (128) for providing a feedback signal (130, 154) to the input path (118), the feedback signal (130, 154) representing an output (132) of the quantizer (106), the output (y) comprising a quantization noise spectrum (172); and
   a circuit component (138, 152) configured to attenuate the quantization noise spectrum (172) at a fold-back frequency from which noise is folded back (174) into a signal band of interest (170) of the quantizer input signal (120).

**2.** Modulator according to claim 1 wherein
for attenuating the quantizer (106) input signal the circuit component (138, 152) is configured for generating a notch in the quantization noise spectrum at the fold back frequency.

**3.** Modulator according to claim 1 or 2, further comprising:

the input path (118) comprising an analogue filter (102);
a chopping modulator (111) coupled to the filter (102) and configured for operating at a chopping frequency ($f_{chop}$);
the fold-back frequency being a function of the chopping frequency ($f_{chop}$).

**4.** Modulator according to claim 3, the fold-back frequency being an even harmonic of the chopping frequency ($f_{chop}$).

**5.** Modulator according to any one of the preceding claims, wherein the chopping modulator (111) is configured for operating at a chopping frequency fchop = fs/2p, wherein fs is the sampling frequency of the quantizer (106) and p is an integer.

**6.** Modulator according to any one of the preceding claims, wherein the circuit component (138, 152) comprises a filter (138) coupled between an output of the quantizer (106) and the feedback path (128), a transfer function (G) of the digital filter having notches at even harmonics of the chopping frequency ($f_{chop}$).

**7.** Modulator according to claim 6, wherein the filter (138) is a finite impulse response filter.

**8.** Modulator according to any one of the preceding claims, wherein
the feedback path (128) is a first feedback path;
the circuit component (138, 152) comprises a second feedback path (142) coupling an output of the quantizer (106) to the input path (118).

**9.** Modulator according to any one of claims 3 to 8,
the analogue filter being a first analogue filter;
the input path (118) comprising a second analogue filter (104) coupled between the first analogue filter (102) and the input (107) of the quantizer (106); and
the second feedback path (142) being coupled to the second analogue filter (104).

**10.** Modulator according to any one of the preceding claims,
the circuit component (138, 152) comprising an error-feedback loop (152);
the error-feedback loop (152) being coupled to the input of the quantizer (106) and to the output (109) of the quantizer (106) and being configured for generating a signal representative of a quantization error of the quantizer (106);
the error-feedback loop (152) being further coupled to the input path (118) for subtracting the signal (154) indicative of the quantization error from a signal (156) in the input path (118), thereby generating the quantizer (106) input signal provided to the quantizer (106).

**11.** Modulator according to the preceding claim, wherein the error-feedback loop comprises a filter (162) configured as to provide a transfer function (G) which is close to 1 at the fold back frequency for passing the signal (154) indicative of the quantization error at the fold back frequency.

**12.** Modulator according to any one of claims 10 or 11, wherein a second digital filter (166) is coupled between the output (109) of the quantizer (106) and an output (126) of the modulator (100, 200, 300, 400).

**13.** Method of operating a quantizer (106) of a modulator (100, 200, 300, 400), the method comprising:

feeding an quantizer input signal (120) to the quantizer (106);
providing a feedback signal (130, 154) to the input path (118), the feedback signal (130, 154) representing an output (132) of the quantizer (106), the output (132) comprising a quantization noise spectrum (172); and
attenuating the quantization noise spectrum (172) at a fold-back frequency from which noise is folded back (174) into a signal band of interest (170) of the quantizer (106) input signal (120).

**14.** Computer program product, in particular in the form of a computer program or in the form of a computer readable medium comprising the computer program, for controlling the operation of a modulator, the computer program being configured for, when being executed on a data processor device, controlling the method according to claim 13.

Fig. 1

Fig. 2

Fig. 3

Fig. 4

Fig. 5

Fig. 6

Fig. 7

Fig. 8

Fig. 9

Fig. 10

Fig. 11

174    174

168

172

170

170

2*fchop        4*fchop        f

Fig. 12

y

168

172

176        176

2*fchop        4*fchop        f

Fig. 13

Europäisches
Patentamt

European
Patent Office

Office européen
des brevets

# EUROPEAN SEARCH REPORT

Application Number

EP 14 16 0161

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | MULLER RIKKY ET AL: "24.1 A miniaturized 64-channel 225[mu]W wireless electrocorticographic neural se", IEEE INTERNATIONAL SOLID STATE CIRCUITS CONFERENCE, IEEE SERVICE CENTER, NEW YORK, NY, US, 9 February 2014 (2014-02-09), pages 412-413, XP032575050, ISSN: 0193-6530, DOI: 10.1109/ISSCC.2014.6757492 ISBN: 978-1-4799-0918-6 [retrieved on 2014-03-05] * page 412, left-hand column * * figures 24.1.2,24.1.6 * ----- | 1-4,8-14 | INV. H03M3/00 |
| X | KERTH D A ET AL: "AN OVERSAMPLING CONVERTER FOR STRAIN GAUGE TRANSDUCERS", IEEE JOURNAL OF SOLID-STATE CIRCUITS, IEEE SERVICE CENTER, PISCATAWAY, NJ, USA, vol. 27, no. 12, December 1992 (1992-12), pages 1689-1696, XP000329017, ISSN: 0018-9200, DOI: 10.1109/4.173094 * page 1692, left-hand column * * figures 8,9,10 * ----- | 1-4, 10-14 | |
| X | US 2004/141562 A1 (PLISCH MARJORIE R [US] ET AL) 22 July 2004 (2004-07-22) * paragraphs [0051] - [0055] * * figures 7,10,11,13 * * paragraph [59.60] * ----- | 1,2,6-8, 10-14 | |

TECHNICAL FIELDS SEARCHED (IPC)

H03M

-/--

The present search report has been drawn up for all claims

| Place of search | Date of completion of the search | Examiner |
|---|---|---|
| The Hague | 12 September 2014 | Rocha, Daniel |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

................................................................

& : member of the same patent family, corresponding document

EPO FORM 1503 03.82 (P04C01)

Europäisches
Patentamt

European
Patent Office

Office européen
des brevets

# EUROPEAN SEARCH REPORT

Application Number

EP 14 16 0161

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | LAKDAWALA H ET AL: "A 1.05 V 1.6 mW, 0.45 C 3 Resolution Based Temperature Sensor With Parasitic Resistance Compensation in 32 nm Digital CMOS Process", IEEE JOURNAL OF SOLID-STATE CIRCUITS, IEEE SERVICE CENTER, PISCATAWAY, NJ, USA, vol. 44, no. 12, December 2009 (2009-12), pages 3621-3630, XP011285526, ISSN: 0018-9200, DOI: 10.1109/JSSC.2009.2035553 * Section IV.C * * Section IV.B * * Section IV.A * * Section V * * figures 11,12,13 * | 1-7, 10-14 | |
| T | CHRISTIAN C ENZ ET AL: "Circuit Techniques for Reducing the Effects of Op-Amp Imperfections: Autozeroing, Correlated Double Sampling, and Chopper Stabilization", PROCEEDINGS OF THE IEEE, IEEE. NEW YORK, US, vol. 84, no. 11, November 1996 (1996-11), XP011043780, ISSN: 0018-9219 * Section III * | 1-12 | TECHNICAL FIELDS SEARCHED (IPC) |
| T | J. C. Candy: "Delta-Sigma Data Converters" In: "Delta-Sigma Data Converters: theory, design and simulation", January 1997 (1997-01), IEEE Press, United States of America, XP55139987, ISBN: 978-0-78-031045-2 pages 22-25, * pages 23-24 * | 10-12 | |

The present search report has been drawn up for all claims

| Place of search | Date of completion of the search | Examiner |
|---|---|---|
| The Hague | 12 September 2014 | Rocha, Daniel |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 14 16 0161

This annex lists the patent family members relating to the patent documents cited in the above-mentioned European search report.
The members are as contained in the European Patent Office EDP file on
The European Patent Office is in no way liable for these particulars which are merely given for the purpose of information.

12-09-2014

| Patent document cited in search report | Publication date | Patent family member(s) | | Publication date |
|---|---|---|---|---|
| US 2004141562 A1 | 22-07-2004 | EP | 1590934 A2 | 02-11-2005 |
| | | JP | 2006518131 A | 03-08-2006 |
| | | US | 2004141562 A1 | 22-07-2004 |
| | | WO | 2004066642 A2 | 05-08-2004 |

EPO FORM P0459

For more details about this annex : see Official Journal of the European Patent Office, No. 12/82

**EP 2 919 388 A1**

**Patent documents cited in the description**

- US 20120038500 A1
- US 20120188107 A1